Europäisches Patentamt

European Patent Office

Office européen des brevets

(19)

(11) **EP 0 453 214 B1**

(12) **EUROPEAN PATENT SPECIFICATION**

(45) Date of publication and mention
of the grant of the patent:
**17.07.1996 Bulletin 1996/29**

(51) Int Cl.6: **H01L 39/24**

(21) Application number: **91303318.9**

(22) Date of filing: **16.04.1991**

(54) **Oxide superconductor and process for producing the same**

Oxydsupraleiter und Verfahren zu dessen Herstellung

Supraconducteur d'oxyde et procédé pour sa fabrication

(84) Designated Contracting States:
**DE FR GB**

(30) Priority: **18.04.1990 JP 102496/90**
**27.03.1991 JP 62997/90**

(43) Date of publication of application:
**23.10.1991 Bulletin 1991/43**

(73) Proprietor: **HITACHI CHEMICAL CO., LTD.**
**Shinjuku-ku, Tokyo (JP)**

(72) Inventors:
- **Yamana, Shozo**
  **Hitachi-shi (JP)**
- **Kuwajima, Hideji**
  **Katsuta-shi (JP)**
- **Sumiya, Keiji**
  **Katsuta-shi (JP)**
- **Shimoda, Shuichiro**
  **Katsuta-shi Ibaraki-ken 312 (JP)**
- **Ashizawa, Toranosuke**
  **Katsuta-shi (JP)**
- **Ishihara, Minoru**
  **Katsuta-shi (JP)**

(74) Representative: **Senior, Alan Murray et al**
**J.A. KEMP & CO.,**
**14 South Square,**
**Gray's Inn**
**London WC1R 5LX (GB)**

(56) References cited:
**EP-A- 0 292 126**          **WO-A-89/01706**

- **PHYSICA C, no. 5&6, 1 April 1990, AMSTERDAM,
  NL pages 408 - 412; Tiefel T. H. et al: 'Recovery
  of high-Tc superconductivity in Y-Ba-Cu-O
  doped with reacting metals'**
- **Phys.Rev.Lett., Vol.58, No.16, 20 April 1987,
  pages 1676-1679; R.J.Cava et al.**

**Description**

BACKGROUND OF THE INVENTION

This invention relates to an oxide superconductor and a process for production thereof.

Among the superconducting intermetallic compounds, those so far used as a superconductor such as $Nb_3Sn$, $GaV_3$, $Nb_3Ge$ and the like have relatively high critical temperatures of 16.8-23 K. Further, they show a critical magnetic field of 20-40 Tesla at a temperature of 4.2 K. For these reasons, they have practically been used not only as superconducting coil but also as Josephson devices and the like.

However, the above-mentioned intermetallic compounds $Nb_3Sn$, $GaV_3$, etc. are all disadvantageous in that the temperature at which they show superconductivity is low. For example, in all of them, the temperature at which they begin to show a superconductivity (hereinafter referred to as $T_c^{onset}$) and the temperature at which they show a complete superconductivity and a resistance of zero (hereinafter referred to as $T_c^{zero}$) are both not higher than 30 K.

Thus, their practical use as a superconductor requires the use of quite expensive liquid helium as a cooling medium. Further, the use of liquid helium disadvantageously complicates the apparatus.

Thus, as an improvement thereof, superconductors using compounds of Ba-La-Cu-O were developed as disclosed in New Superconducting Materials Forum, Ist Symposium Proceeding, pp. 24-33 (1987). By these superconductors, the critical temperature was raised above 30 K. Further, by superconductors using Y-Ba-Cu-O compounds subsequently found, the critical temperature was raised to the order of 90 K, which temperature is higher than the liquid nitrogen temperature of 77.3 K.

A superconductor using the above-mentioned Y-Ba-Cu-O compound has as high a critical current density (hereinafter referred to as Jc) as $1 \times 10^8$ $A/m^2$ if measured at the liquid nitrogen temperature in a magnetic field of 1 Tesla, in case of a Y-Ba-Cu-O superconductor prepared by melting a Y-Ba-Cu-O series compound at a temperature of 1,200°C or above and slowly cooling it, as disclosed in, for example, "Nikkei Superconductors" vol. 18, pp. 1-2 (published on October 3, 1988).

However, the thus obtained superconductors are disadvantageous in that their production process, i.e. melting at a high temperature followed by slow cooling, requires a special apparatus and they are limited in size and shape, although they acquire a high Jc.

On the other hand, as disclosed in New Superconducting Materials Forum Workshop Proceeding, pp. 23-36 (published on September 17, 1987), Y-Ba-Cu-O superconductors prepared by press-forming Y-Ba-Cu-O compounds and thereafter sintering them have a Jc value of $1 \times 10^5$ - $10^6$ $A/m^2$ at the liquid nitrogen temperature. But, the thus obtained superconductors are disadvantageous in that they cannot acquire a high Jc, although they are easy and simple to produce.

Superconductors using Y-Ba-Cu-O compounds are disadvantageous in that their Jc is greatly dependent on a magnetic field. For example, as disclosed in JAPANESE JOURNAL OF APPLIED PHYSICS, vol. 27, No. 2, pp. 185-187, their Jc greatly decreases when the magnetic field is as weak as $10^{-2}$ T.

EP-A-0,292,126 discloses Y-Ba-Cu-O superconductors using small amounts of added metal, primarily Ag, to improve their mechanical, electrical and thermal properties.

It is an object of this invention to provide an oxide superconductor free from the above-mentioned disadvantages and a process for producing said oxide superconductor.

The present inventors conducted many studies on improvement of Jc in superconductors of Y-Ba-Cu-O series compounds. As a result of the studies, it was found that, if platinum and/or palladium is added to a Y-Ba-Cu-O series compound and firing it, a high Jc can be achieved though secondary phases are formed and that the magnetic field dependency of Jc can also be improved by the secondary phases.

The present invention provides a sintered oxide superconductor product comprising a superconductive crystal phase containing yttrium, barium, copper and oxygen in an atomic ratio of 1 : 1.25-2.15 : 1.75-3.5 : 3-8.5 , and secondary phases formed by adding platinum and/or palladium to a yttrium-barium-copper-oxygen-containing compound in an amount of 0.1 to 5% by weight based on the weight of the total composition.

The present invention also provides a method of making the above described superconductor comprising the steps of

mixing raw materials containing yttrium, barium, and copper so as to make the predetermined composition,
firing the mixture,
grinding the mixture,
mixing raw materials containing platinum and/or palladium with the ground mixture, and
molding and firing the resulting mixture.

In this invention, if all the crystal phase exhibit superconductivity, the ratios between yttrium, barium, copper and oxygen are not particularly limited. If atomic ratio yttrium : barium : copper : oxygen is in the range of 1 : 1.25-2.15 : 1.75-3.5 : 3-8.5, namely $Y_{1.0}Ba_{1.25-2.15}Cu_{1.75-3.5}O_{3-8.5}$, preferably 1 : 1.85-2.15 : 2.5-3.5 : 5.8-7.2, namely $Y_{1.0}Ba_{1.85-2.15}Cu_{2.5-3.5}O_{5.8-7.2}$, a high Jc and a small magnetic field dependency are achieved, which is desirable.

When a crystal phase exhibiting no superconductivity and a crystal phase exhibiting superconductivity coexist, the composition of the crystal phase exhibiting superconductivity represented by atomic ratio yttrium : barium : copper : oxygen should be in the range of 1 : 1.25-2.15 : 1.75-3.5 : 3-8.5, preferably 1 : 1.85-2.15 : 2.5-3.5 : 5.8-7.2, namely $Y_{1.0}Ba_{1.85-2.15}Cu_{2.5-3.5}O_{5.8-7.2}$. If the composition is out of this range, a high Jc is not achieved and dependency on magnetic field is great, which is undesirable. In the above-mentioned compositions, the oxygen content can be 6.4 to 7.0 in atomic ratio.

Raw materials for the yttrium, barium and copper used as major components constituting the superconducting material are not limitative. Examples of the raw materials are as follows. As raw material of yttrium, yttrium oxide ($Y_2O_3$), yttrium carbonate ($Y_2(CO_3)_3.3H_2O$), yttrium oxalate ($Y_2(C_2O_4)_3.9H_2O$), yttrium nitrate ($Y(NO_3)_3.6H_2O$), yttrium sulfate ($Y_2(SO_4)_3$), trimethoxyyttrium ($Y(OCH_3)_3$), triethoxyyttrium ($Y(OC_2H_5)_3$), triisopropoxyyttrium ($Y(O-i-C_3H_7)_3$), yttrium bromide ($YBr_3$), yttrium fluoride ($YF_3.1/2 H_2O$), yttrium iodide ($YI_3$) and the like are used either singly or in combination of two or more members.

As the raw material of barium, barium oxide (BaO), barium peroxide ($BaO_2$), barium carbonate ($BaCO_3$), barium nitrate ($Ba(NO_3)_2$), barium sulfate ($BaSO_4$), barium hydroxide ($Ba(OH)_2).8H_2O$), barium alkoxides [$Ba(O-CH_3)_2$, $Ba(O-C_2H_5)_2$, $Ba(O-i-C_3H_7)_2$, $Ba(O-n-C_3H_7)_2$, $Ba(O-i-C_4H_9)_2$, $Ba(O-n-C_4H_9)_2$, $Ba(O-sec-C_4H_9)_2$, $Ba(O-tert-C_4H_9)_2$, and the like j, barium bromide ($BaBr_2$), barium chloride ($BaCl_2$), barium fluoride ($BaF_2$), barium iodide ($BaI_2$), barium sulfide (BaS) and the like are used either singly or in combination of two or more members.

As the raw material of copper, cupric oxide (CuO) is preferably used, though other copper oxides and copper compounds are also usable.

The platinum and/or palladium is used in an amount ranging from 0.1% to 5% by weight based on the weight of the total composition. If its amount is less than 0.1% by weight, high Jc is not achievable and the magnetic field dependency is not improved. If its amount exceeds 5% by weight, high Jc is not achievable.

As the platinum, platinum powder and platinum dioxide ($PtO_2$) are preferably used, though other platinum compounds are also usable.

As the palladium, palladium powder and palladium oxide (PdO) are preferably used, though other palladium compounds are also usable.

The mixing can be carried out by a conventional method, for example, a method which comprises charging balls coated with synthetic resin, solvent such as ethanol, methanol or the like and raw materials into a ball mill made of synthetic resin and wet mixing them, or a method which comprises mixing the raw materials in an automatic mortar in dryness.

Although the firing temperature may be decided appropriately in accordance with formulation of raw materials, etc., the firing is preferably carried out in the temperature range of 900-1,050°C, in air or in an oxygen-containing atmosphere.

The pulverization can be carried out by a conventional method using a zirconia ball mill, mortar, and the like.

The oxide superconductors of the present invention can also be produced by mixing raw materials containing yttrium, barium, and copper so as to make the predetermined composition, firing the mixture preferably at a temperature of 900° to 1250°C in air or an oxygen-containing atmosphere, grinding the mixture, mixing raw materials containing platinum and/or palladium with the ground mixture, and molding the resulting mixture and firing the molded mixture at a temperature of 900 to 1250°C in air or an oxygen-containing atmosphere. When the initial firing temperature is lower, the final firing temperature is preferably made higher.

The present invention is illustrated by way of the following Examples wherein all parts and % are by weight unless particularly specified.

Example 1 and Comparative Example 1

As raw materials, $Y_2O_3$ (manufactured by Shin-Etsu Chemical Industry Co., Ltd.; purity 99.9%), $BaCO_3$ (manufactured by Wako Pure Chemical Industries, Ltd.; reagent of guaranteed grade) and CuO (manufactured by Kojundo Kagaku K.K.; purity 99.9%) were weighed out so that the atomic ratio of Y, Ba and C came to 1:2:3, and wet mixed together by means of a ball mill made of synthetic resin for 24 hours. Subsequently, the mixture was dried at 100°C for 12 hours to obtain a mixed powder. To 100 parts of the mixed powder was added 3 parts of polyvinyl alcohol (manufactured by Wako Pure Chemical Industries, Ltd.; reagent) as an organic binder. After uniformly mixing the mixture, it was formed into a molded product having a diameter of 30 mm in diameter and a thickness of 2 mm, under a pressure of 100 MPa. Then, the molded product was fired in an atmosphere of oxygen at 950°C for 10 hours to obtain a sintered product. Then, the sintered product was roughly crushed in an agate mortar and wet pulverized for 24 hours in a ball mill made of zirconia to obtain a superconductor powder having a mean particle diameter of 2.0 μm.

# EP 0 453 214 B1

Subsequently, platinum powder (manufactured by Tokuriki Chemical Research Co., Ltd.; trade name TP-1) was mixed into the superconductor powder at a ratio shown in Table 1, and 3 parts of polyvinyl alcohol (manufactured by Wako Pure Chemical Industries, Ltd.; reagent) as an organic binder was added to 100 parts of the mixed powder. After uniformly mixing the resulting mixture, it was formed into a molded product having a diameter of 30 mm in diameter and a thickness of 2 mm under a pressure of 98 MPa. Then, the molded product was fired and sintered in an atmosphere of oxygen at 950°C for 10 hours to obtain a sintered product of platinum-containing oxide superconductor.

Table 1

| Sample No. | Formulation (%) | |
|---|---|---|
| | Superconductor powder | Platinum |
| *1 | 100 | 0 |
| 2 | 99.8 | 0.2 |
| 3 | 99.5 | 0.5 |
| 4 | 99.0 | 1.0 |
| 5 | 98.0 | 2.0 |
| 6 | 97.0 | 3.0 |
| 7 | 95.0 | 5.0 |
| *8 | 90.0 | 10.0 |

Note: The mark * signifies that the sample is out of this invention.

In the firing process, the temperature was elevated up to 500°C at a rate of 100°C/hour, and from 500°C up to 950°C at a rate of 200°C/hour. The cooling was carried out down to 300°C at a rate of 100°C/hour, and thereafter the material was allowed to cool down to ambient temperature in the oven.

Then, the sintered product was cut into pieces having a width of 2 mm. On the test pieces thus obtained, the change of resistance depending on temperature change was measured by the 4-probe method, and $T_c^{zero}$, Jc and Jc in magnetic field were measured. Jc was calculated from a current at a voltage drop of 1 $\mu$V/cm and sectional area of test piece.

Table 2 shows $T_c^{zero}$ and Jc of the platinum-containing sintered products herein obtained. Table 3 shows Jc in magnetic field of the sintered products No. 1, No. 3 and No. 4.

Table 2

| Sample No. | $T_c^{zero}$ (K) | Jc ($\times 10^4$ A/m²) | Sample No. | $T_c^{zero}$ (K) | Jc ($\times 10^4$ A/m²) |
|---|---|---|---|---|---|
| *1 | 92.4 | 310 | 5 | 92.4 | 810 |
| 2 | 92.0 | 650 | 6 | 92.1 | 840 |
| 3 | 93.1 | 800 | 7 | 92.7 | 780 |
| 4 | 92.9 | 880 | *8 | 92.1 | 420 |

## Table 3

| Magnetic field ($\times 10^{-4}$ T) / Sample No. | Jc ($\times 10^4$ A/m$^2$) | | | | | |
|---|---|---|---|---|---|---|
| | 0 | 5 | 10 | 50 | 100 | 200 |
| 1 | 310 | 200 | 80 | 60 | 50 | 40 |
| 3 | 800 | 790 | 780 | 400 | 120 | 100 |
| 4 | 880 | 860 | 860 | 420 | 125 | 95 |

Table 2 and Table 3 show that the oxide superconductors of this invention are higher in Jc and smaller in the decrease of Jc in the magnetic field of 5-10 x 10$^{-4}$ Tesla as compared with oxide superconductors containing no platinum. Further, $T_c^{zero}$ of the oxide superconductors of this invention is as good as 92.0-93.1 K.

Contrariwise, oxide superconductors containing no platinum have Jc of as low as 310 x 10$^4$ A/m$^2$ and their Jc greatly decreases in the magnetic field of 5-10 x 10$^{-4}$ Tesla, although their $T_c^{zero}$ is as good as 92.4 K.

Oxide superconductors containing 10% of platinum show a good $T_c^{zero}$ of 92.1 K, but their Jc is as low as 420 x 10$^4$ A/m$^2$.

Example 2 and Comparative Example 2

Sintered products of palladium-containing oxide superconductors were produced by repeating the procedure of Example 1, except that the platinum powder in Example 1 was replaced by palladium powder (manufactured by Tokuriki Chemical Research Co., Ltd.; trade name #301). The amount of palladium was as shown in Table 4.

Table 4

| Sample No. | Formulation (%) | |
|---|---|---|
| | Superconductor powder | Palladium |
| *11 | 100 | 0 |
| 12 | 99.8 | 0.2 |
| 13 | 99.5 | 0.5 |
| 14 | 99.0 | 1.0 |
| 15 | 98.0 | 2.0 |
| 16 | 97.0 | 3.0 |
| 17 | 95.0 | 5.0 |
| *18 | 90.0 | 10.0 |

Next, on the sintered products thus obtained, $T_c^{zero}$, Jc and Jc in magnetic field were measured in the same manner as in Example 1.

Table 5 shows $T_c^{zero}$ and Jc of these palladium containing sintered products. Table 6 shows Jc in magnetic field of the sintered products No. 11, No. 13 and No. 14.

Table 5

| Sample No. | $T_c^{zero}$ (K) | Jc ($\times 10^4$ A/m$^2$) | Sample No. | $T_c^{zero}$ (K) | Jc ($\times 10^4$ A/m$^2$) |
|---|---|---|---|---|---|
| *11 | 92.5 | 320 | 15 | 92.1 | 740 |
| 12 | 92.3 | 610 | 16 | 93.0 | 800 |
| 13 | 93.2 | 780 | 17 | 92.8 | 710 |
| 14 | 92.9 | 820 | *18 | 91.9 | 450 |

Table 6

| Magnetic field ($\times 10^{-4}$ T) Sample No. | Jc ($\times 10^4$ A/m$^2$) | | | | | |
|---|---|---|---|---|---|---|
| | 0 | 5 | 10 | 50 | 100 | 200 |
| *11 | 320 | 190 | 70 | 50 | 30 | 20 |
| 13 | 780 | 760 | 760 | 380 | 100 | 90 |
| 14 | 820 | 810 | 800 | 390 | 110 | 90 |

Table 5 and Table 6 show that the oxide superconductors of this invention are higher in Jc and smaller in the decrease of Jc in the magnetic field of 5-10 x 10$^{-4}$ Tesla as compared with oxide superconductors containing no platinum. Further, the oxide superconductors of this invention show a good $T_c^{zero}$ of 91.9-93.2 K.

Contrariwise, in the oxide superconductors containing no platinum, Jc is as low as 320 x 10$^4$ A/m$^2$ and their Jc greatly decreases in the magnetic field of 5-10 x 10$^{-4}$ Tesla, although $T_c^{zero}$ is as good as 92.5 K.

Further, oxide superconductors containing 10% of palladium show a good $T_c^{zero}$ of 91.9 K, but their Jc is as low as 450 x 10$^4$ A/m$^2$.

Since the oxide superconductors obtained according to this invention has $T_c^{zero}$ of 77 K or above, they are usable in liquid nitrogen, their Jc can be enhanced, and they show only a small decrease of Jc in magnetic field. Accordingly, the oxide superconductors of this invention can be quite successfully usable industrially.

**Claims**

1. A sintered oxide superconductor product comprising a superconductive crystal phase containing yttrium, barium, copper and oxygen in an atomic ratio of 1 : 1.25-2.15 : 1.75-3.5 : 3-8.5 , and secondary phases formed by adding platinum and/or palladium to a yttrium-barium-copper-oxygen-containing compound in an amount of 0.1 to 5% by weight based on the weight of the total composition.

2. A sintered oxide superconductor product according to claim 1 wherein the composition of a crystal phase exhibiting superconductivity comprises yttrium, barium, copper and oxygen in an atomic ratio of 1 : 1.85-2.15 : 2.5-3.5 : 5.8-7.2.

3. A process for producing the sintered oxide superconductor product as defined in claim 1, which comprises

   mixing raw materials containing yttrium, barium, and copper so as to make a predetermined composition,
   firing the mixture,
   grinding the mixture,
   mixing raw materials containing platinum and/or palladium with the ground mixture, and
   molding and firing the resulting mixture.

**Patentansprüche**

1. Gesintertes Oxid-Supraleiter-Produkt, das eine supraleitende Kristallphase, die Yttrium, Barium, Kupfer und Sauerstoff in einem Atomverhältnis von 1 : 1,25 bis 2,15 : 17,5 bis 3,5 : 3 bis 8,5 enthält, und sekundäre Phasen, die durch Zugabe von Platin und/oder Palladium zu einer Yttrium-Barium-Kupfer-Sauerstoff enthaltenden Verbindung in einer Menge von 0,1 bis 5 Gew.-%, bezogen auf das Gewicht der Gesamtzusammensetzung, gebildet worden sind, umfaßt.

**2.** Gesintertes Oxid-Supraleiter-Produkt nach Anspruch 1, dadurch **gekennzeichnet**, daß die Zusammensetzung der Supraleitfähigkeit aufweisenden Kristallphase Yttrium, Barium, Kupfer und Sauerstoff in einem Atomverhältnis von 1 : 1,85 bis 2,15 : 2,5 bis 3,5 : 5,8 bis 7,2 umfaßt.

**3.** Verfahren zur Herstellung des gesintertes Oxid-Supraleiter-Produkts nach Anspruch 1, dadurch **gekennzeichnet**, daß

Rohmaterialien, die Yttrium, Barium und Kupfer enthalten, so vermischt werden, daß eine vorbestimmte Zusammensetzung erhalten wird,

das Gemisch gebrannt wird,

das Gemisch vermahlen wird,

die Rohmaterialien, die Platin und/oder Palladium enthalten, mit dem vermahlenen Gemisch vermischt werden, und

das resultierende Gemisch geformt und gebrannt wird.

**Revendications**

**1.** Produit supraconducteur en oxyde fritté comprenant une phase cristalline supraconductrice contenant de l'yttrium, du barium, du cuivre et de l'oxygène en un rapport atomique de 1/1,25-2,15/1,75-3,5/3-8,5, et des phases secondaires formées par addition de platine et/ou de palladium à un composé contenant de l'yttrium, du barium, du cuivre et de l'oxygène en une quantité comprise entre 0,1 et 5 % en poids par rapport au poids de la composition totale.

**2.** Produit supraconducteur en oxyde fritté conforme à la revendication 1 dans lequel la composition d'une phase cristalline présentant une supraconductivité comprend de l'yttrium, du barium, du cuivre et de l'oxygène en un rapport atomique de 1/1,85-2,15/2,5-3,5/5,8-7,2.

**3.** Procédé de fabrication du produit supraconducteur en oxyde fritté conforme à la revendication 1, lequel procédé comprend

- le mélangeage des matières brutes contenant de l'yttrium, du barium et du cuivre de manière à préparer une composition prédéterminée,
- la cuisson du mélange,
- le broyage du mélange,
- le mélangeage des matières brutes contenant du platine et/ou du palladium avec le mélange broyé, et
- moulage et cuisson du mélange résultant.